# EUROPEAN PATENT APPLICATION

(11) **EP 3 447 508 A1**
(43) Date of publication of application: **27.02.2019**
(21) Application number: 17206452.9
(22) Date of filing: 11.12.2017
(51) Int. Cl.: G01R 31/12

(54) **SYSTEM AND METHOD FOR DETECTING PARTIAL DISCHARGE IN A SWITCHGEAR CABINET**

(30) Priority: 23.08.2017 GB 201713510
(71) Applicant: EA Technology Limited, Chester, Cheshire CH1 6ES (GB)
(72) Inventor: CODD, Peter Sandell, Chester CH1 6ES (GB); DEVINE, Gareth Anthony, Chester CH1 6ES (GB); HUGHES, Siôn Wyn, Chester CH1 6ES (GB); PLATTS, William Edward, Chester CH1 6ES (GB); EARP, Graham Keith, Chester CH1 6ES (GB)
(74) Representative: Prichard, Leslie Stephen

(57) **Abstract**

The present invention relates to a partial discharge detection system, comprising:
a plurality of partial discharge sensors mounted within an electrical switchgear cabinet; and
monitoring means for monitoring the output of the plurality of sensors and outputting at least one output signal based on detected partial discharge activity.

## Description

### TECHNICAL FIELD OF THE INVENTION

This invention relates to a system and method for detecting partial discharge in a switchgear cabinet. In particular, the present invention relates to a switchgear cabinet which comprises an integrated partial discharge sensor arrangement, and to a partial discharge sensor arrangement for permanent fixture in a switchgear cabinet, and to a method of detecting and localising a partial discharge event in a switchgear cabinet.

### BACKGROUND

For many years, it has been known to monitor both medium and high voltage switchgear and substation assets for partial discharge activity and which can provide an early warning of the deterioration of assets.

Partial discharge is a well-understood mechanism which begins within voids, cracks or inclusions within solid insulation, or in bubbles with liquid insulation. Partial discharge is a localised dielectric breakdown of a small portion of a solid or liquid electrical insulation system under high voltage stress but which does not completely bridge the space between the conductors. Once begun, partial discharge causes progressive deterioration or degradation of insulation material, and ultimately leads to dielectric breakdown and hence asset failure.

Partial discharge activity can be detected using various laboratory and field-testing methods. One of the most popular and convenient methods of detection is to measure transient earth voltages induced in the surrounding metalwork of the switchgear asset. Transient earth voltages provide a reliable and convenient means for detecting partial discharge.

For many years, it has been known to detect partial discharge via periodic inspections using hand-held instruments without making any electrical connection to the switchgear asset.

More recently an improved quantity and quality of partial discharge data can be obtained by using permanent monitoring equipment. There are problems associated with the use of permanent monitoring equipment in that the partial discharge sensors, data collection and communication modules have to be retrofitted either inside and/or outside the switchgear asset under test. This can sometimes cause operational and scheduling issues, and the retrofitting of permanent monitoring equipment is a capital investment that requires specialist skill and knowledge to ensure reliable performance.

Whilst the market for remote monitoring systems continues to grow there is a need for a switchgear cabinet which comprises an integrated partial discharge sensor arrangement, and to a partial discharge sensor arrangement for permanent fixture in a switchgear cabinet, and to a method of detecting and localising a partial discharge event in a switchgear cabinet all of which can be used to continuously monitor and detect partial discharge events either independently, or as part of the switchgear cabinet's condition monitoring and control system.

It is an object of the present invention to provide a system and method for detecting partial discharge in a switchgear cabinet which overcomes or reduces the drawbacks associated with known products of this type. It is an object of the present invention to provide a switchgear cabinet which comprises an integrated partial discharge sensor arrangement, and to a partial discharge sensor arrangement for permanent fixture in a switchgear cabinet which quickly and reliably detects and localises partial discharge events in real time or near real time. The present invention can be utilised as part of the switchgear cabinet's condition monitoring and control system, and thereby share resources and reduce component and processing requirements.

### SUMMARY OF THE INVENTION

The present invention is described herein and in the claims.

According to a first aspect of the present invention there is provided a partial discharge detection system, comprising:
a plurality of partial discharge sensors mounted within an electrical switchgear cabinet; and
monitoring means for monitoring the output of the plurality of sensors and outputting at least one output signal based on detected partial discharge activity.

An advantage of the present invention is that it can be used to continuously and reliably detect and localise partial discharge activity in real time or near real time in an unobtrusive manner.

Preferably, the plurality of partial discharge sensors and the monitoring means are mounted inside the electrical switchgear cabinet.

Further preferably, the electrical switchgear cabinet comprises one or more MV or HV switchgear compartments, and wherein each of the one or more switchgear compartments is divided into at least three sub compartments which comprise a bus bar chamber or bus duct, a circuit breaker compartment and cable termination compartment.

In use, the number of partial discharge sensors may be three, and each sensor being mounted inside the bus bar chamber or bus duct, the circuit breaker compartment and the cable termination compartment respectively.

Preferably, the monitoring means being mounted inside any one of the bus bar chamber or bus duct, the circuit breaker compartment or the cable termination compartment.

Further preferably, the plurality of partial discharge sensors are wideband antennas.

In use, the wideband antennas may be configured having printed radiating elements.

Preferably, the monitoring means is associated with, or integrated within, an oversight system, the oversight system having one or more host units connected thereto.

Further preferably, the oversight system includes electrical equipment condition monitoring and switchgear control functionality.

In use, the monitoring means may further comprise:
a plurality of input channels each being connected to the output of the plurality of partial discharge sensors;
filter means for rejecting out of band sensed signals;
multiplexer means for receiving and combining the filtered signals;
amplifier means for amplifying and extracting the envelope of the multiplexed signal;
peak detector means for measuring the pulse peak amplitude and phase of the envelope signal;
comparator means for comparing the envelope signal to a partial discharge trigger level;
storage means for storing the triggered pulse peak amplitude and phase; and
processing means.

Preferably, in the event of a partial discharge trigger level being triggered the processing means passing the stored data to the oversight system.

Further preferably, the partial discharge detection system further comprising anti-surge protection means positioned between the output of the plurality of partial discharge sensors and the plurality of input channels.

In use, the filter means may be a band pass filter.

Preferably, the processing means is connected to the oversight system via a Serial Peripheral Interface bus and Modbus interface.

Further preferably, the partial discharge trigger level and the determination of the location of detected partial discharge activity is carried out by a detection algorithm.

In use, the partial discharge detection system may further comprise self-test power feeds connected to each of the plurality of partial discharge sensors, and which energise a self-test signal to allow the operation of the plurality of partial discharge sensors to be verified.

Preferably, the partial discharge detection system further comprising a precedence monitoring means for detecting partial discharge activity along a section of bus bar chamber or bus duct.

Further preferably, the precedence monitoring means comprises two wideband antennas which are positioned at, or near, the two opposite ends of the bus bar chamber or bus duct.

In use, the precedence monitoring means may further comprise:
a pair of input channels each being connected to the output of the two wideband antennas;
filter means for rejecting out of band sensed signals;
amplifier means for amplifying and extracting the envelope of the filtered signals;
peak detector means for measuring the pulse peak amplitude and phase of the envelope signal;
comparator means for comparing the envelope signal to a partial discharge trigger level;
precedence means for receiving the triggered output from the two input channels and measuring the difference in arrival time of the signals;
storage means for storing the pulse peak amplitude, phase and arrival time difference; and
processing means.

Preferably, the partial discharge detection system further comprising an offset signal which compensates for differing cable lengths between the two wideband antennas.

According to a second aspect of the present invention an electrical switchgear cabinet comprising at least one partial discharge detection system according to the first aspect of the present invention.

According to a third aspect of the present invention there is provided a system for processing data from a plurality of partial discharge sensors, the system determines the severity and/or location of partial discharge activity within switchgear or a bus duct.

According to a fourth aspect of the present invention there is provided a method of detecting partial discharge activity in an electrical switchgear cabinet, the method comprising the steps of:
mounting a plurality of partial discharge sensors within the electrical switchgear cabinet; and
monitoring the output of the plurality of sensors and outputting at least one signal based on detected partial discharge activity.

It is believed that a partial discharge detection system and its method of use and an electrical switchgear cabinet in accordance with the present invention at least addresses the problems outlined above.

It will be obvious to those skilled in the art that variations of the present invention are possible and it is intended that the present invention may be used other than as specifically described herein.

### BRIEF DESCRIPTION OF THE DRA WINGS

The present invention will now be described by way of example only, and with reference to the accompanying drawings, in which:
Figure 1 shows a schematic diagram of a switchgear cabinet comprising a plurality of partial discharge detection sensors in accordance with the present invention;
Figure 2 illustrates schematically how the switchgear cabinet of Figure 1 can additionally include a further arrangement of partial discharge detection sensors to detect a partial discharge event along a section of bus bar chamber or bus duct;
Figure 3 is a circuit block diagram of the partial discharge detection system of the present invention; and
Figure 4 shows a circuit block diagram for detecting a partial discharge event based on the time of arrival at the two sensors positioned at each end bus bar chamber or bus duct, as shown in Figure 2.

### DETAILED DESCRIPTION OF THE PREFERRED EMBODIMENTS

The present invention has adopted the approach of utilising a system and method for detecting partial discharge in a switchgear cabinet. Advantageously, the present invention provides a switchgear cabinet which comprises an integrated partial discharge sensor arrangement, and a partial discharge sensor arrangement for permanent fixture in a switchgear cabinet, which quickly and reliably detects and localises partial discharge events in real time or near real time. Further advantageously, the present invention can be utilised as part of the switchgear cabinet's condition monitoring and control system, and thereby share resources and reduce component and processing requirements.

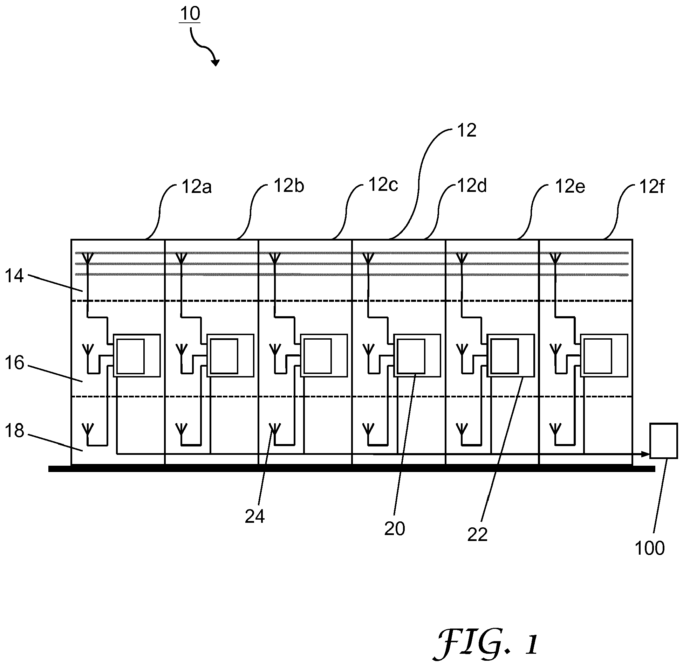

Referring now to the drawings, a partial discharge detection system 10 for use within a switchgear cabinet 12 according to the present invention is illustrated in Figure 1. The switchgear cabinet 12 shown in Figure 1 comprises a number of compartments, being numbered as compartments 12a to 12f in the six-tier switchgear panel 12 shown for illustrative purposes only in Figure 1. The skilled person will understand that each of the six compartments 12a to 12f are divided into three sub compartments, namely the bus bar 14, circuit breaker 16 and cable termination compartments 18 which form the switchgear panel 12.

Each of the three sub compartments is shown schematically in Figure 1 and being delimited by dashed lines.

The partial discharge detection system 10 of the present invention is configured as a series of monitoring units or cards 20. Each monitoring unit 20 being associated with each compartment 12a to 12f of the switchgear panel 12, such that for six-tier switchgear panel 12 shown for illustrative purposes in Figure 1, there are six monitoring units or cards 20.

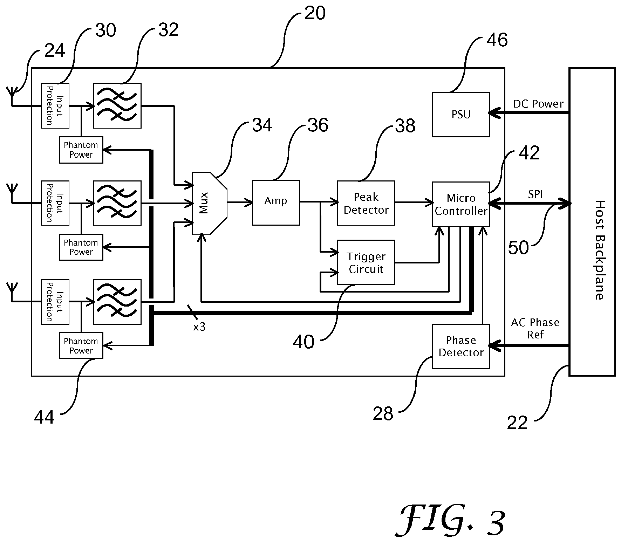

Each monitoring unit 20 is also associated with, or forms part of, a condition monitoring and control oversight system 100. The oversight system 100 can be implemented having a series of host cards 22 which are present in each compartment 12a to 12f of the switchgear panel 12. The oversight system 100 can be one that is already installed within the switchgear cabinet 12 for circuit breaker control, and environmental and condition monitoring. In essence, the monitoring unit 20 is implemented as a microcontroller 42 that receives a number of inputs, and outputs data to the host system 22 via a number of outputs. The microcontroller can be considered a self-contained system with a processor, memory and peripherals. The electrical power supply for each monitoring unit 20 can be supplied from the host system 22, or separately. All collected data from each monitoring unit 20 is made available via a Serial Peripheral Interface (SPI) bus 50 to the host system 22, as shown in Figure 3. The skilled person will appreciate that other communication interfaces and protocols are possible, and which are within the scope of the present invention.

Each monitoring card 20 is installed within the host system's 22 backplane within each compartment 12a to 12f of the panel 12.

Each monitoring card 20 accepts inputs from three wideband antennas 24 and each wideband antenna 24 is installed in each HV sub compartment 14, 16, 18 of the panel 12 to enable comprehensive monitoring of partial discharge activity. The present invention detects the amplitude and count rate measurement of received signals on each of the three channels, and makes use of time-multiplexed scanning of the three sensed inputs to reduce component costs and share resources, as described further in relation to Figure 3.

Significant attenuation is encountered between sub compartments 14, 16, 18 and this necessitates the use of an antenna 24 within each sub compartment 14, 16, 18 to ensure adequate coverage and it also means that relatively computationally straightforward detection algorithms based on amplitude comparison can be used to detect and determine the point of origin of the partial discharge source in the panel 12.

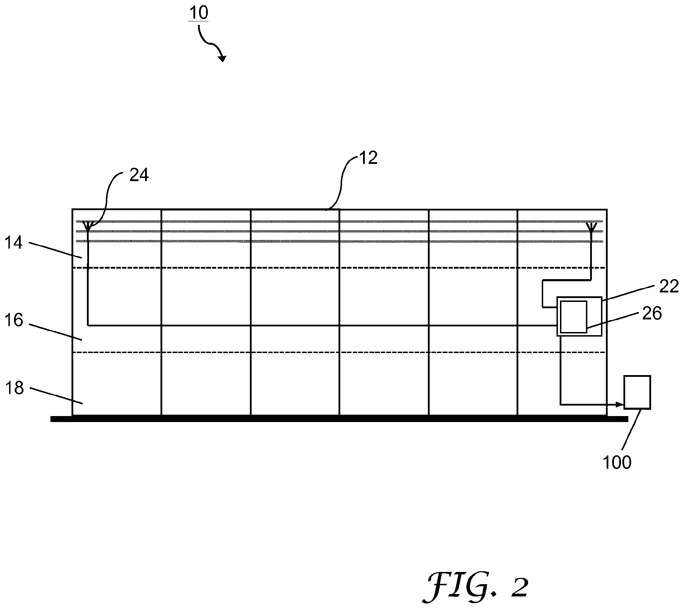

The present invention may also make use of a further precedence monitoring unit 26 which will be used wherever there is the need to monitor partial discharge activity on either a length of bus bar chamber or bus duct 14, as illustrated in Figure 2. It has been found that signals propagate very effectively along bus ducts and on some bus bar chambers 14. This means that signal amplitude cannot be used to determine point of origin. Instead the second monitoring unit 26 makes use of time of flight of the signal and arrival time at the wideband antennas 24 at the two ends thereof to allow the point of origin of the signal to be determined.

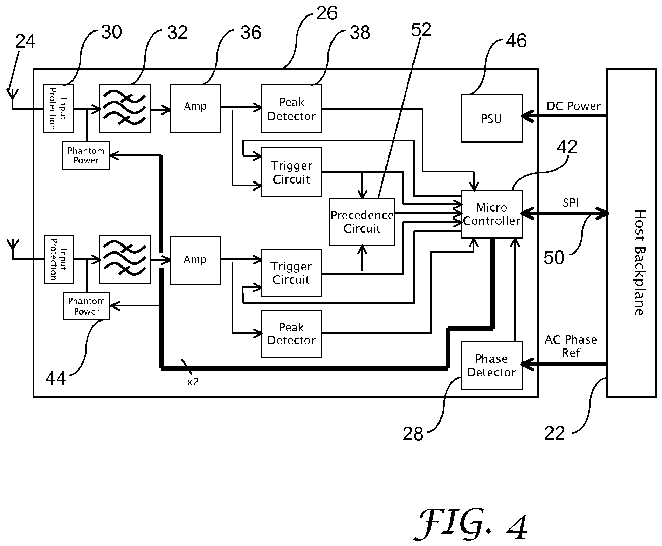

The precedence monitoring unit 26 receives inputs from the two wideband antennas 24 and provides non-multiplexed amplitude measurement on each and precedence functionality between the two inputs, as described further in relation to Figure 4.

The antennas 24 are all configured as a two conductor transmission line having a characteristic impedance of 50Ω.

A circuit block diagram of each monitoring card 20 is shown in Figure 3. Figure 3 shows that the monitoring unit 20 is designed to mount within the host card 22 and from which it accepts power 46 and the SPI communication bus 50. On the front of the card 20 are ports (not shown) for the connection of three wideband antennas 24 which are mounted within the bus bar 14, circuit breaker 16 and cable termination compartments 18 of the switchgear cabinet 12. A phase reference signal 28 is also inputted to each monitoring card 20.

Anti-surge protection circuits 30 are present on the antenna input channels 24 and the phase reference input 28.

The monitoring card 20 measures the signals from the antennas 24 in terms of pulse amplitude and phase position relative to the supplied phase reference 28, and then stores this data locally. It determines various averages and metrics to aid with partial discharge signal localisation, as described below.

The signals from the antennas 24 in response to partial discharge events take the form of a narrow oscillatory pulse with dominant frequencies in the several hundred MHz range. To process these signals the card 20 first applies a bandpass filter 32 to reject any out of band signals and reduce susceptibility to noise. The three input channels are then time division multiplexed 34 into a single measurement circuit.

The measurement circuit uses an amplifier 36 to extract the envelope of the RF pulse. This envelope signal then passes to an analogue peak detector circuit 38 for measurement of the pulse peak amplitude and a comparator 40 which is used for event or trigger detection. The output from peak detector 38 and comparator 40 are inputted to a microcontroller 42 which detects the pulse event, measures the pulse amplitude and records the data for later access by the host unit 22.

Also present on the card 20 are phantom power feeds 44 to each of the antenna 24 ports. These are used to energise a self-test signal built into the antenna 24 to allow the system operation to be verified. Switching of phantom power feeds 44 is controlled by the microcontroller 42 under the command of the host unit 22.

The firmware in the microcontroller 42 will be responsible for taking measurements on the three sensor input channels 24, as described below.

The phase and amplitude of each event occurring on the measured channel are recorded. The recording will take the form of incrementing the appropriate element of a 2D array where each column represents a discrete range of phase angles and each row represents a discrete range of amplitudes. The number of phase and amplitude bins will be configurable over the SPI interface 50 and this setting will be saved to flash memory and retained across power cycles.

At the end of each integration period the software will calculate statistics for each channel, including those based on measurement algorithms. These algorithms are designed to locate the signal to within a sub compartment 14, 16, 18 of the switchgear panel 12.

The result of these calculations will be available over the SPI bus 50 together with the most active phase bins.

In order to confirm the most active bins are representative of the partial discharge pattern the total number of 'active' bins will also be transmitted with the data. The SPI bus 50 will then be able to request further data in groups of bins, and this data will be transferred with the most active bins first. The bins will only be overwritten when the host 22 signals it has completed the transfers.

The firmware implements an automatic level control (ALC) on each measurement channel. The purpose of this is to set the trigger level appropriately such that a high level of background noise triggers are not generated, whilst all real partial discharge events are captured.

As noted above, the phase reference input 28 is provided to the monitoring card 20. The firmware is responsible for processing this signal to generate a phase locked counter running at a multiple of the line frequency, which is used for phase stamping individual events. The lock status being available over the SPI port 50.

The firmware in the microcontroller 42 is also configured to provide the following functionality and features:

On power up, the firmware can provide a power on self-test procedure, details of which are well known to those skilled in the art and its description here is not critical. The firmware will also include watchdog functionality which will reset the processor 42 if the code fails to regularly refresh the watchdog. On power up, the watchdog flag will be tested as part of the power on self-test to detect watchdog resets.

It will also be possible to trigger the re-running of the power on self-test at any time under command from the SPI port 50. An SPI command will also allow each self-test circuit 44 to be activated and deactivated.

The firmware is also able to be updated according to known procedures available in the art and its description here is not critical.

Figure 4 shows further detail of the precedence monitoring card 26. The precedence card 26 is similar in many ways to the monitoring unit 20 in that it is mounted within the host rack 22 from which it accepts power 46, a phase reference signal 28 and SPI communication bus 50. On its front panel are ports for the connection of two wideband antennas 24 which are positioned at two ends of the bus duct or bus bar section 14 being monitored.

The signal processing pulse detection and measurement techniques are virtually identical to the monitoring card 20 and so will not be described further here. The only significant difference is that the precedence card 26 only has two antenna 24 input channels rather than three, and these are both monitored continuously rather than being time division multiplexed. This allows simultaneous pulses on both channels to be captured.

An additional precedence block 52 receives the trigger output from the two channels and measures the difference in arrival time of the signal on the two channels down to ns resolution. This is stored in addition to the pulse amplitude and phase position. If the length of the section being monitored and the propagation speed of signals down the section are both known, then the time difference can be used to determine the point of origin of the partial discharge signal on the bus bar chamber or bus duct 14.

It is envisaged that the same physical PCB (with build options for the two variants) will be used to cater for both the monitoring 20 and precedence cards 26.

The firmware functionality of the precedence card 26 will be very similar to monitoring card 20. A hardware link on the PCB could be used to identify which type of board 20, 26 the code is running on and so allow the firmware to enable only the appropriate functions.

Since the precedence card 26 firmware will support the simultaneous continuous measurement on two channels as opposed to the single measurement channel time division multiplexed between three sensor channels of the monitoring card 20, this will necessitate two ALC and trigger blocks 38.

The firmware will require an additional register for the calibration of the timing circuit. This register will be populated on commissioning with the offset in ns between the two channels. This offset will allow for differing cable lengths between the two sensors.

On each partial discharge event that is seen on both input channels the firmware will process the output to determine the relative time of arrival of the signal between the two channels. The results of this measurement will be stored as a single histogram, or 1D array, where each element represents the number of times that a discrete delta time has been seen. This data will be made available over the SPI port 50.

Therefore, the system and method according to the present invention quickly and reliably detects and localises partial discharge events in real time or near real time

When used in this specification and claims, the terms "comprises" and "comprising" and variations thereof mean that the specified features, steps or integers are included. The terms are not to be interpreted to exclude the presence of other features, steps or components.

The features disclosed in the foregoing description, or the following claims, or the accompanying drawings, expressed in their specific forms or in the terms of a means for performing the disclosed function, or a method or process for attaining the disclosed result, as appropriate, separately, or in any combination of such features, can be utilised for realising the invention in diverse forms thereof.

The invention is not intended to be limited to the details of the embodiments described herein, which are described by way of example only. It will be understood that features described in relation to any particular embodiment can be featured in combination with other embodiments.

It is contemplated by the inventor that various substitutions, alterations, and modifications may be made to the invention without departing from the spirit and scope of the invention as defined by the claims.

### CLAUSES

The following clauses define preferred embodiments of the invention.
1. A partial discharge detection system, comprising:
   a plurality of partial discharge sensors mounted within an electrical switchgear cabinet; and
   monitoring means for monitoring the output of the plurality of sensors and outputting at least one output signal based on detected partial discharge activity.
2. The partial discharge detection system according to clause 1, wherein the plurality of partial discharge sensors and the monitoring means are mounted inside the electrical switchgear cabinet.
3. The partial discharge detection system according to clauses 1 or 2, wherein the electrical switchgear cabinet comprises one or more MV or HV switchgear compartments, and wherein each of the one or more switchgear compartments is divided into at least three sub compartments which comprise a bus bar chamber or bus duct, a circuit breaker compartment and cable termination compartment.
4. The partial discharge detection system according to clause 3, wherein the number of partial discharge sensors is three, and each sensor being mounted inside the bus bar chamber or bus duct, the circuit breaker compartment and the cable termination compartment respectively.
5. The partial discharge detection system according to clause 4, wherein the monitoring means being mounted inside any one of the bus bar chamber or bus duct, the circuit breaker compartment or the cable termination compartment.
6. The partial discharge detection system according to any of clauses 1 and 3 to 5, wherein the plurality of partial discharge sensors are wideband antennas.
7. The partial discharge detection system according to clause 6, wherein the wideband antennas are configured having printed radiating elements.
8. The partial discharge detection system according to clause 1, wherein the monitoring means is associated with, or integrated within, an oversight system, the oversight system having one or more host units connected thereto.
9. The partial discharge detection system according to clause 8, wherein the oversight system includes electrical equipment condition monitoring and switchgear control functionality.
10. The partial discharge detection system according to any of the preceding clauses, wherein the monitoring means further comprises:
   a plurality of input channels each being connected to the output of the plurality of partial discharge sensors;
   filter means for rejecting out of band sensed signals;
   multiplexer means for receiving and combining the filtered signals;
   amplifier means for amplifying and extracting the envelope of the multiplexed signal;
   peak detector means for measuring the pulse peak amplitude and phase of the envelope signal;
   comparator means for comparing the envelope signal to a partial discharge trigger level;
   storage means for storing the triggered pulse peak amplitude and phase; and
   processing means.
11. The partial discharge detection system according to clause 10, wherein in the event of a partial discharge trigger level being triggered the processing means passing the stored data to the oversight system.
12. The partial discharge detection system according to clauses 10 or 11, further comprising anti-surge protection means positioned between the output of the plurality of partial discharge sensors and the plurality of input channels.
13. The partial discharge detection system according to clause 10, wherein the filter means is a band pass filter.
14. The partial discharge detection system according to clause 1, wherein the processing means is connected to the oversight system via a Serial Peripheral Interface bus and Modbus Interface.
15. The partial discharge detection system according to clause 1, wherein the partial discharge trigger level and the determination of the location of detected partial discharge activity is carried out by a detection algorithm.
16. The partial discharge detection system according to clause 1, further comprising self-test power feeds connected to each of the plurality of partial discharge sensors, and which energise a self-test signal to allow the operation of the plurality of partial discharge sensors to be verified.
17. The partial discharge detection system according to any of the preceding clauses, further comprising a precedence monitoring means for detecting partial discharge activity along a section of bus bar chamber or bus duct.
18. The partial discharge detection system according to clause 17, wherein the precedence monitoring means comprises two wideband antennas which are positioned at, or near, the two opposite ends of the bus bar chamber or bus duct.
19. The partial discharge detection system according to clause 18, wherein the precedence monitoring means further comprises:
   a pair of input channels each being connected to the output of the two wideband antennas;
   filter means for rejecting out of band sensed signals;
   amplifier means for amplifying and extracting the envelope of the filtered signals;
   peak detector means for measuring the pulse peak amplitude and phase of the envelope signal;
   comparator means for comparing the envelope signal to a partial discharge trigger level;
   precedence means for receiving the triggered output from the two input channels and measuring the difference in arrival time of the signals;
   storage means for storing the pulse peak amplitude, phase and arrival time difference; and
   processing means.
20. The partial discharge detection system according to clause 19, further comprising an offset signal which compensates for differing cable lengths between the two wideband antennas.
21. An electrical switchgear cabinet comprising at least one partial discharge detection system according to any of the preceding clauses.
22. A system for processing data from a plurality of partial discharge sensors, the system determines the severity and/or location of partial discharge activity within switchgear or a bus duct.
23. A method of detecting partial discharge activity in an electrical switchgear cabinet, the method comprising the steps of:
   mounting a plurality of partial discharge sensors within the electrical switchgear cabinet; and
   monitoring the output of the plurality of sensors and outputting at least one signal based on detected partial discharge activity.

## Claims

1. A partial discharge detection system, comprising:
a plurality of partial discharge sensors mounted within an electrical switchgear cabinet; and
monitoring means for monitoring the output of the plurality of sensors and outputting at least one output signal based on detected partial discharge activity.

2. The partial discharge detection system as claimed in claim 1, wherein the plurality of partial discharge sensors and the monitoring means are mounted inside the electrical switchgear cabinet; and/or optionally,
wherein the electrical switchgear cabinet comprises one or more MV or HV switchgear compartments, and wherein each of the one or more switchgear compartments is divided into at least three sub compartments which comprise a bus bar chamber or bus duct, a circuit breaker compartment and cable termination compartment.

3. The partial discharge detection system as claimed in claim 2, wherein the number of partial discharge sensors is three, and each sensor being mounted inside the bus bar chamber or bus duct, the circuit breaker compartment and the cable termination compartment respectively; and/or optionally,
wherein the monitoring means being mounted inside any one of the bus bar chamber or bus duct, the circuit breaker compartment or the cable termination compartment.

4. The partial discharge detection system as claimed in any of the preceding claims, wherein the plurality of partial discharge sensors are wideband antennas.

5. The partial discharge detection system as claimed in claim 4, wherein the wideband antennas are configured having printed radiating elements.

6. The partial discharge detection system as claimed in claim 1, wherein the monitoring means is associated with, or integrated within, an oversight system, the oversight system having one or more host units connected thereto, and wherein the oversight system includes electrical equipment condition monitoring and switchgear control functionality.

7. The partial discharge detection system as claimed in any of the preceding claims, wherein the monitoring means further comprises:
a plurality of input channels each being connected to the output of the plurality of partial discharge sensors;
filter means for rejecting out of band sensed signals;
multiplexer means for receiving and combining the filtered signals;
amplifier means for amplifying and extracting the envelope of the multiplexed signal;
peak detector means for measuring the pulse peak amplitude and phase of the envelope signal;
comparator means for comparing the envelope signal to a partial discharge trigger level;
storage means for storing the triggered pulse peak amplitude and phase; and
processing means.

8. The partial discharge detection system as claimed in claim 7, wherein in the event of a partial discharge trigger level being triggered the processing means passing the stored data to the oversight system.

9. The partial discharge detection system as claimed in claims 7 or 8, further comprising anti-surge protection means positioned between the output of the plurality of partial discharge sensors and the plurality of input channels; and/or optionally,
wherein the filter means is a band pass filter.

10. The partial discharge detection system as claimed in claim 1, wherein the processing means is connected to the oversight system via a Serial Peripheral Interface bus and Modbus Interface; and/or optionally,
wherein the partial discharge trigger level and the determination of the location of detected partial discharge activity is carried out by a detection algorithm.

11. The partial discharge detection system as claimed in claim 1, further comprising self-test power feeds connected to each of the plurality of partial discharge sensors, and which energise a self-test signal to allow the operation of the plurality of partial discharge sensors to be verified; and/or optionally,
further comprising a precedence monitoring means for detecting partial discharge activity along a section of bus bar chamber or bus duct.

12. The partial discharge detection system as claimed in claim 11, wherein the precedence monitoring means comprises two wideband antennas which are positioned at, or near, the two opposite ends of the bus bar chamber or bus duct; and/or optionally,
wherein the precedence monitoring means further comprises:
a pair of input channels each being connected to the output of the two wideband antennas;
filter means for rejecting out of band sensed signals;
amplifier means for amplifying and extracting the envelope of the filtered signals;
peak detector means for measuring the pulse peak amplitude and phase of the envelope signal;
comparator means for comparing the envelope signal to a partial discharge trigger level;
precedence means for receiving the triggered output from the two input channels and measuring the difference in arrival time of the signals;
storage means for storing the pulse peak amplitude, phase and arrival time difference; and
processing means.

13. The partial discharge detection system as claimed in claim 12, further comprising an offset signal which compensates for differing cable lengths between the two wideband antennas.

14. An electrical switchgear cabinet comprising at least one partial discharge detection system as claimed in any of the preceding claims.

15. A method of detecting partial discharge activity in an electrical switchgear cabinet, the method comprising the steps of:
mounting a plurality of partial discharge sensors within the electrical switchgear cabinet; and
monitoring the output of the plurality of sensors and outputting at least one signal based on detected partial discharge activity.
